# EUROPÄISCHE PATENTANMELDUNG

(11) **EP 2 747 279 A1**
(43) Veröffentlichungstag der Anmeldung: **25.06.2014**
(21) Anmeldenummer: 13196646.7
(22) Anmeldetag: 11.12.2013
(51) Int. Cl.: H03F 1/08, H03F 1/22

(54) **Transimpedanzverstärker und dessen Verwendung für eine abtastende optoelektronische Detektionseinrichtung**

(30) Priorität: 14.12.2012 DE 102012024488
(71) Anmelder: Valeo Schalter und Sensoren GmbH, 74321 Bietigheim-Bissingen (DE)
(72) Erfinder: Kabuk, Uensal, 22041 Hamburg (DE)

(57) **Zusammenfassung**

Die Erfindung betrifft einen Transimpedanzverstärker (6) betätigbaren und dessen Verwendung für eine abtastende optoelektronische Detektionseinrichtung (1), insbesondere Laserscanner für Kraftfahrzeuge.

Um bei möglichst geringen Kosten für die Transimpedanzverstärkung eine hohe Verstärkung bei ausreichend hoher Bandbreite zu ermöglichen, ist erfindungsgemäß ein Transimpedanzverstärker (6) mit mehreren diskret hintereinander geschalteten Verstärkerstufen vorgesehen, wobei eine erste Stufe (21) als Transimpedanzverstärkungsschaltung ausgebildet ist und die weiteren Stufen als Span-nungsverstärkungsschaltungen,

## Beschreibung

Die Erfindung betrifft einen Transimpedanzverstärker mit Transistorschaltungen zur Verstärkung eines elektrischen Empfangssignals gemäß dem Oberbegriff des Patentanspruchs 1. Die Erfindung betrifft außerdem die Verwendung eines solchen Transimpedanzverstärkers für eine abtastende optoelektronische Detektionseinrichtung, insbesondere eines Laserscanners, für ein Kraftfahrzeug, gemäß Patentanspruch 9.

Im Automobilbereich werden unterschiedlichste Fahrerassistenzsysteme zur Detektion von Objekten eingesetzt, um den Fahrer beim Führen des Kraftfahrzeugs zu unterstützen. Laser-basierte Systeme, beispielsweise "Lidar"-Systeme (Lidar = "Light detection and ranging") können mit einer großen Reichweite vom Fahrzeug entfernt liegende Objekte mit einer hohen Messgenauigkeit erkennen. Derartige Systeme werden beispielsweise im Frontbereich von Fahrzeugen angeordnet, etwa im Bereich der Windschutzscheibe oder aber am Kühlergrill.

Ein Laserscanner weist üblicherweise einen optischen Sender auf, welcher kurze Laserimpulse aussendet. Die reflektierten Strahlen werden mittels eines Empfängers eingefangen, welcher die empfangenen Strahlen in ein elektrisches Empfangssignal umwandelt und für eine anschließende Auswertung bereit stellt. Hierzu ist beispielsweise eine Fotodiode in dem Empfänger angeordnet, welche das empfangene Licht in elektrischen Strom umwandelt.

DE 10 2010 047 984 A1 offenbart einen abtastenden optischen Entfernungssensor für Kraftfahrzeuge mit einem Laser als optischem Sender und einem als Detektor ausgeführten optischen Empfänger. Der bekannte Entfernungssensor umfasst ferner eine Sendespiegeleinheit mit zwei Sendeumlenkspiegeln sowie eine Empfangsspiegeleinheit mit zwei Empfangsumlenkspiegeln. Der optische Sender erzeugt gepulste Laserstrahlen, welche über die drehbewegliche Sendespiegeleinheit umgelenkt und in den zu überwachenden Bereich abgestrahlt werden. Die empfangenen Laserstrahlen, die in Reaktion auf die ausgesendeten gepulsten Laserstrahlen von Objekten bzw. Hindernissen reflektiert werden, werden über die Empfangsspiegeleinheit umgelenkt und zum optischen Empfänger geleitet. Das elektrische Signal des optischen Empfängers wird zur Ermittlung der Laufzeit der Laserstrahlen ausgewertet, um die Entfernung zu einem erkannten Objekt im Überwachungsbereich zu übermitteln.

Das elektrische Empfangssignal, welches auf der Grundlage der reflektierten Strahlen bereit gestellt wird, ist ein Strompulssignal, wobei die Ströme relativ schwach sind. Um eine präzise Messung des elektrischen Empfangssignals zu ermöglichen, wird oft ein Transimpedanzverstärker eingesetzt. Der Transimpedanzverstärker wandelt das empfangene Strompulssignal in ein Spannungssignal um und verstärkt das Empfangssignal dabei derart, das es nachfolgend aussagekräftig ausgewertet werden kann.

Der Transimpedanzverstärker muss sowohl über eine hohe Empfindlichkeit als auch über eine hohe Empfangsdynamik verfügen, um bei Einsätzen im Außenbereich, wie an Kraftfahrzeugen, den Anforderungen bei witterungsbedingten Einflüssen, beispielsweise Regen, Gischt oder Nebel, zu genügen.

Transimpedanzverstärker für abtastende optoelektronische Detektionseinrichtungen werden üblicherweise mit integrierten Bausteinen oder mit breitbandigen Operationsverstärkern ausgestattet. Derartige Transimpedanzverstärker können jedoch bei gegebener Bandbreite nicht die in der Anwendung für Kraftfahrzeuge benötigte Verstärkung bereitstellen. Meistens wird ein so genannter Booster-Verstärker benötigt, um zusätzlich zu der Transimpedanzverstärkung eine Spannungsverstärkung vorzunehmen.

Integrierte Transimpedanzverstärker für die Verstärkung optoelektrischer Signale sind häufig auf hohe Datenraten mit Bandbreiten im Gigahertz-Bereich optimiert, wobei jedoch die Verstärkung gering ist. Bei optoelektronischen Detektionseinrichtungen, wie Laserscannern, sind Strompulssignale mit Bandbreiten von bis zu 300 Megahertz zu verstärken, sodass bekannte integrierte Transimpedanzverstärker das Bedürfnis einer hohen Verstärkung bei gleichzeitig hoher Bandbreite und Empfangsdynamik nicht befriedigen können.

Ferner sind die Kosten für integrierte Transimpedanzverstärker sehr hoch. Zudem sind nachweislich hochwertige Schaltkreise, welche beispielsweise nach dem Zuverlässigkeitstest für integrierte Schaltungen AEC-Q100 (AEC = Automotive electronics council) qualifiziert sind, oft nicht in hinreichender Menge für automobilindustrielle Anwendungen zu beschaffen. Auch weisen integrierte Transimpedanzverstärker oft interne schaltungstechnische Maßnahmen auf, welche sich bei der Verstärkung gepulster Signale mit sehr hohen Pegeln nachteilig auswirken. Es kann bei derartigen bekannten Transimpedanzverstärkern zu Signalverzerrungen kommen, welche die Messgenauigkeit und die Messfähigkeit einer optoelektronischen Detektionseinrichtung nachteilig beeinflussen.

Alternativ zu integrierten Transimpedanzverstärkern ist der Einsatz von Operationsverstärkern als Transimpedanzverstärker bekannt. Operationsverstärker verfügen über eine spezielle interne Kompensation, um höhere Bandbreiten zu erreichen. Allerdings arbeiten derartig konfigurierte Operationsverstärker oft nicht stabil. Es kann bei Einsatz von Operationsverstärkern mit gepulsten Signalen und hoher Dynamik und entsprechenden Pegeln des Eingangsstroms zu Instabilitäten kommen, welche die Messfähigkeit und die Messgenauigkeit nachteilig beeinflussen. Durch Maßnahmen zur externen Kompensation werden die erreichbaren Bandbreiten eingeschränkt.

Der vorliegenden Erfindung liegt das Problem zu Grunde, bei möglichst geringen Kosten für die Transimpedanzverstärkung die Nachteile bekannter Einrichtungen zu vermeiden und eine hohe Verstärkung bei ausreichend hoher Bandbreite zu ermöglichen.

Dieses Problem wird erfindungsgemäß durch einen Transimpedanzverstärker mit den Merkmalen des Patentanspruchs 1 gelöst. Außerdem wird das Problem gemäß Patentanspruch 9 durch die Verwendung eines solchen Transimpedanzverstärkers für eine abtastende optoelektronische Detektionseinrichtung gelöst.

Der erfindungsgemäße Transimpedanzverstärker weist mehrere diskret hintereinander geschaltete Verstärkerstufen auf. Eine erste Stufe, das heißt die am Eingang der Gesamtschaltung des Transimpedanzverstärkers liegende Stufe ist dabei als Transimpedanzverstärkungsschaltung ausgebildet und die weiteren Stufen als Spannungsverstärkungsschaltungen. Diese Verstärkerstufen sind jeweils Transistor- Verbundschaltungen, sodass durch den Einsatz handelsüblicher Hochfrequenztransistoren die Kosten für den Transimpedanzverstärker gering gehalten werden können. Dabei können leicht verfügbare zuverlässige Transistoren eingesetzt werden, welche beispielsweise der AEC-Q100 Qualifizierung genügen. Der diskrete Aufbau des erfindungsgemäßen Transimpedanzverstärkers mit mindestens drei hintereinander geschalteten Verstärkerstufen ermöglicht zudem die Wahl einer höheren Betriebsspannung der Schaltung als bei handelsüblichen Verstärker IC's. Die Betriebsspannung beträgt vorzugsweise mindestens 7 Volt, wobei sich eine Betriebsspannung von 10 Volt als besonders vorteilhaft herausgestellt hat. Die hohe Betriebsspannung ermöglicht eine optimale Einstellung der Arbeitspunkte der eingesetzten Transistoren bezüglich der Signalaussteuerbarkeit und wirkt sich vorteilhaft auf die Dynamik der Gesamtschaltung aus.

Bevorzugt weist wenigstens eine der weiteren Stufen eine ausgangsseitige Kollektorschaltung und eine derartige Konfiguration auf, dass das Empfangssignal am Eingang des Transimpedanzverstärkers und das Signal in der Kollektorschaltung dieser Stufe phasengleich sind. Mit einer solchen Abstimmung isoliert die Kollektorschaltung diese Stufe nicht nur von der Spannungsverstärkungsschaltung der anschließenden Stufe, sondern begrenzt auch die Amplitude im Großsignalbetrieb des Transimpedanzverstärkers. Auch bei sehr hohen Pegeln des Empfangssignals wird daher stets ein elektrisches Signal mit begrenzter Amplitude zur nächsten Stufe durchgeschaltet. Dabei ist die Konfiguration mit einem Signal in der Kollektorschaltung mit dergleichen Phasenlage wie das Empfangssignal des Transimpedanzverstärkers vorzugsweise für die zweite Stufe, oder allgemein die vorletzte Stufe einer Mehrstufigen Anordnung, vorgesehen, so dass der letzten Verstärkerstufe ein komprimiertes Signal zugeführt ist parasitäre Effekte und Signalverzerrungen bei sehr hohen Eingangsstrompegeln im Transimpedanzverstärker vermieden sind.

Die Kollektorschaltung der zweiten Stufe ist bezüglich des Arbeitspunktes so konfiguriert, dass es mit dem anliegenden elektrischen Signal in der vorgesehenen Phasenlage optimal ausgesteuert werden kann. Die Kollektorschaltung der zweiten Stufe und die Spannungsverstärkungsschaltung der dritten Stufe werden derartig durch entsprechende Ausbildung und Anordnung der elektronischen Bauteile konfiguriert, dass mit der dadurch gegebenen Ausgangsimpedanz der Kollektorschaltung der zweiten Stufe und der Eingangsimpedanz der dritten Stufe die Amplitude des Empfangssignals im Großsignalbetrieb optimal begrenzt ist. Dabei ist eine hohe Dynamik des Transimpedanzverstärkers gegeben. Die Begrenzung der Signalamplitude wird durch den Emitterwiderstand der Kollektorschaltung der zweiten Stufe eingestellt.

Bei der Konfiguration der Kollektorschaltung der zweiten Stufe wird die effektive Emitterimpedanz derartig gewählt, dass sich sowohl die gewünschte Signalkompression durch Amplitudenbegrenzung als auch ein niedrig dimensionierter Arbeitsstrom in der Kollektorschaltung einstellt. Demzufolge ist die Verlustleistung der zweiten Stufe möglichst gering gehalten.

Durch den Einsatz von drei Verstärkerstufen wird eine hohe Gesamtverstärkung erreicht, wobei die Schaltung durch entsprechende Anordnung und Auswahl der der eingesetzten elektronischen Bauteile auf eine möglichst hohe Bandbreite, vorzugsweise bis zu 200 Megahertz, bei möglichst geringer Verlustleistung optimiert wird. Mit ausgangsseitigen Kollektorschaltungen werden die Spannungsverstärkungsschaltungen von einander isoliert, sodass jede einzelne Stufe als separate Transistorschaltung aufgebaut werden kann.

In einer vorteilhaften Ausführungsform weist die erste Stufe, das heißt die Transimpedanzverstärkungsschaltung, eine Kaskodenschaltung und eine zusätzliche Kollektorschaltung auf. In der Kaskodenschaltung arbeitet ein Eingangstransistor in Emitterschaltung und ein Ausgangstransistor in Basisschaltung, wobei der Ausgangstransistor am Emitteranschluss einen niedrigen Eingangswiderstand aufweist und dadurch der so genannte Millereffekt und damit die effektive Eingangskapazität reduziert wird, wodurch eine hohe Bandbreite der Schaltung bereitgestellt ist. Der Arbeitspunkt der Kaskodenschaltung ist vorteilhaft auf das Rauschoptimum der verwendeten Transistoren eingestellt. Die zusätzliche, ausgangsseitige Kollektorschaltung isoliert die Transimpedanzverstärkungsstufe von der nachfolgenden Spannungsverstärkungsstufe.

Vorteilhaft weist die erste Stufe eine Rückkopplung über einen Rückkopplungswiderstand auf den Eingang der Kaskodenschaltung auf, sodass die Transimpedanz der ersten Stufe auf einfache Weise durch geeignete Bestimmung der Größe des Rückkopplungswiderstands einstellbar ist. Die Rückkopplung auf den Eingang der Kaskodenschaltung stabilisiert zudem den Arbeitspunkt der Kaskodenschaltung.

In einer weiteren vorteilhaften Ausführungsform der Erfindung ist dem Eingangstransistor der Kaskodenschaltung eine Schottky-Diode oder eine andere Schutzdiode zum Spannungsabbau zugeordnet, wodurch die Schaltung bei hohen Eingangsströmen geschützt wird und verhindert wird, dass sich am Ausgang Fehldetektionen bilden können. Die Schottky-Diode ist in der Basis-Emitter-Strecke des in der Emitterschaltung betriebenen Eingangstransistors der Kaskodenschaltung angeordnet. Dadurch ist ein stärkeres Empfangssignal am Eingang der Schaltung als die Durchbruchsspannung der verwendeten Transistoren ausgeschlossen. Bei Empfangssignalen mit sehr hohen Pegeln können nämlich am Ausgang der erfindungsgemäßen Schaltungen Pulsspannungen mit weiten Pulsbreiten auftreten, wobei die der Kaskodenschaltung zugeordnete, das heißt am Eingang der Gesamtschaltung angeordnete, Schottky-Diode einem Zusammenbrechen des Pulses entgegenwirkt. Auf diese Weise wird die Dynamik des erfindungsgemäßen Transimpedanzverstärkers zusätzlich erhöht.

Die Spannungsverstärkungsschaltungen sind in bevorzugter Ausgestaltung der Erfindung als Emitterschaltung mit Stromgegenkopplung und ausgangsseitiger Kollektorschaltung ausgeführt. Durch die Stromgegenkopplung wird der Arbeitspunkt der Emitterschaltung stabilisiert. Die erste Stufe, das heißt die Transimpedanzverstärkungsschaltung, und die zweite Stufe sind gleichstromgekoppelt, wodurch die Basisvorspannung der zweiten Stufe stabilisiert ist. Die Verstärkung der zweiten Stufe wird durch Anordnung und Schaltung der Bauteile frequenzselektiv eingestellt. Die zweite Stufe des erfindungsgemäßen Transimpedanzverstärkers erreicht dadurch eine hohe Wechselstromverstärkung bei gleichzeitiger Stromgegenkopplung und der damit einhergehenden Stabilisierung des Arbeitspunktes.

Die zweite und die dritte Stufe des erfindungsgemäßen Transimpedanzverstärkers sind vorteilhaft wechselstromgekoppelt. Hierzu wird zwischen dem Ausgang der zweiten Stufe und dem Eingang der dritten Stufe ein Kondensator angeordnet. Der Kondensator lässt bekanntlich keinen Gleichstrom, sondern nur Wechselstrom passieren. Der Kondensator koppelt somit die Basis vom Eingangssignal der dritten Stufe gleichstrommäßig ab. Die Wechselstromkopplung der zweiten und der Dritten Stufe des erfindungsgemäßen Transimpedanzverstärkers schafft die Möglichkeit, den Phasenverlauf des Transimpedanzverstärkers über die Frequenz zu linearisieren. Dadurch besitzt die Gesamtschaltung die für die Verarbeitung des gepulsten Empfangssignals des Transimpedanzverstärkers vorteilhafte konstante Gruppenlaufzeit. Ferner trägt die Linearisierung der Phase zur Verringerung von Signalverzerrungen bei und erhöht dadurch zusätzlich die Dynamik des erfindungsgemäßen Transimpedanzverstärkers.

Weitere Merkmale der Erfindung ergeben sich aus den Unteransprüchen und aus den Ausführungsbeispielen, welche nachstehend anhand der Zeichnung näher erläutert sind. Es zeigen:
- Fig. 1: Ein Schaltbild einer Detektionseinrichtung mit einem erfindungsgemäßen Transimpedanzverstärker,
- Fig. 2: Ein elektronisches Schaltbild eines Ausführungsbeispiels eines Transimpedanzverstärkers für eine Detektionseinrichtung gem. Fig. 1.

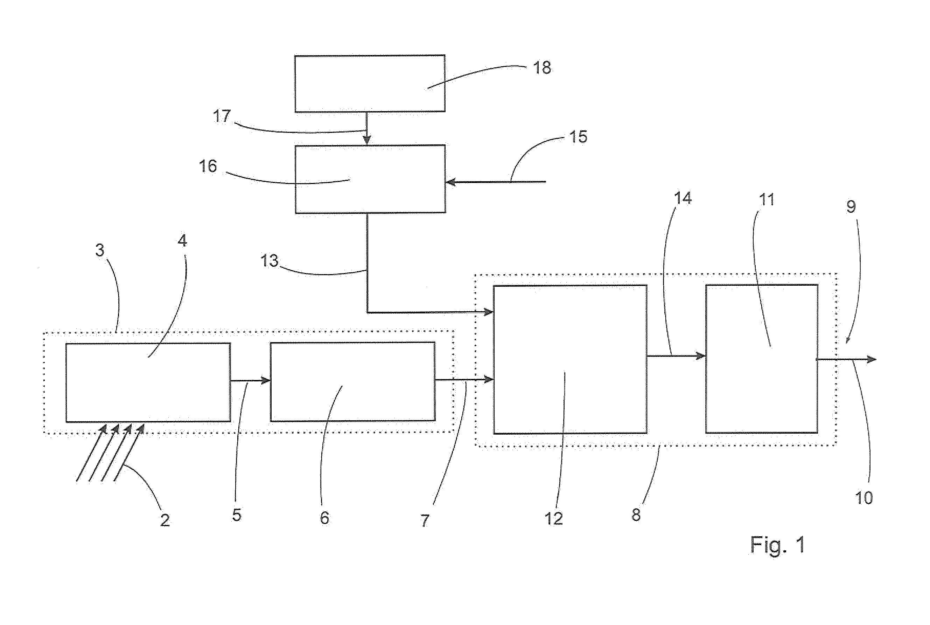

Fig. 1 zeigt einen Teil einer optoelektronischen Detektionseinrichtung 1 eines nicht weiter dargestellten Laserscanners. Der Laserscanner umfasst einen optischen Sender mit einer Laserquelle zum Aussenden von Strahlen sowie einen verschwenkbaren Spiegel. Innerhalb eines Abtastwinkelbereichs tastet die Detektionseinrichtung ein Sichtfeld ab, wobei für eine Vielzahl unterschiedlicher Abtastwinkel innerhalb des Abtastwinkelbereichs schrittweise von der Laserquelle Strahlimpulse ausgesendet werden. Werden diese Strahlen von einem Objekt im Sichtfeld der Detektionseinrichtung 1 reflektiert, so empfängt die Detektionseinrichtung die reflektierte Strahlen 2 über einen optischen Empfänger 3. Der optische Empfänger 3 umfasst ein oder mehrere Empfangselemente 4, insbesondere Fotodioden oder Fototransistoren, welche die empfangenen reflektierten Strahlen in ein korrespondierendes elektrisches Empfangssignal 5 umwandeln. Vorzugsweise sind die Empfangselemente Avalanche- Halbleiterelemente bzw. Avalanche- Fotodioden, weiche die empfangenen reflektierten Strahlen 2 entsprechend dem Puls des Lasersignals in ein Strompulssignal umwandeln.

Der Empfangseinrichtung 4 ist ein nachfolgend noch näher erläuterter Transimpedanzverstärker 6 nachgeordnet, welcher das analoge elektrische Empfangssignal 5 in ein entsprechendes Spannungssignal umwandelt und verstärkt, sodass an dem Ausgang des Transimpedanzverstärkers 6 ein verstärktes Empfangssignal 7 für die anschließende Auswertung bereit steht. Der Transimpedanzverstärker 6 ist im gezeigten Ausführungsbeispiel Teil des optischen Empfängers 3. Der Transimpedanzverstärker 6 kann dabei als separates Bauteil mit entsprechenden Transistorschaltungen ausgebildet sein.

Das verstärkte Empfangssignal 7 wird einer elektronischen Auswertungseinrichtung 8 zugeführt, welche abhängig von dem verstärkten Empfangssignal die Entfernung vom Zielobjekt misst, an dem die Strahlen 2 reflektiert werden. An einem Ausgang 9 der Auswertungseinrichtung 8 werden die ermittelten Entfernungsmesswerte 10 zur weiteren Verwendung, insbesondere in einem Fahrassistenzsystem für Kraftfahrzeuge, abgegeben. Die elektronische Auswertungseinrichtung 8 umfasst neben der eigentlichen Auswertungseinheit 11 einen vorgeschalteten Komparator 12, welcher neben dem verstärkten Empfangssignal 7 des optischen Empfängers 3 mindestens ein weiteres Eingangssignal 13 empfängt. Der Komparator 12 verknüpft die empfangenen Informationen und gibt an seinem Ausgang ein elektrisches Ausgangssignal 14 ab, welches in der Auswertungseinheit 11 nach vorgegebenen Abläufen ausgewertet wird. Das Eingangssignal 13 umfasst im gezeigten Ausführungsbeispiel Informationen in Anhängigkeit vom Abtastwinkel 15 des Laserscanners.

Der Abtastwinkel 15 wird von einem nicht weiter dargestellten Messwertgeber des Laserscanners, beispielsweise am Scannermotor des Laserscanners, abgenommen und einer Steuereinrichtung 16 eingegeben. Die Steuereinrichtung 16 ordnet dem vorgegebenen Abtastwinkel 15 eine Information 17 zu, welche aus einem Speicher 18 ausgelesen wird. Die Steuereinrichtung 16 gibt der elektronischen Auswertungseinrichtung 8 ein dieser Information 17 entsprechendes Eingangssignal 13 vor. Die Information 17 kann dabei eine oder mehrere Detektionsschwellen sein. Durch die winkelabhängige Einstellung der Detektionsschwelle wird der winkelabhängigen Empfindlichkeit des optischen Empfängers 3 Rechnung getragen, welche über den gesamten Abtastwinkelbereich variiert. Der Komparator 12 erzeugt unter Berücksichtigung des verstärkten Empfangssignals 7 und des winkelabhängigen Eingangssignals 13 ein binarisiertes Ausgangssignal 14, welches der Auswertungseinheit 11 vorgegeben wird.

In weiteren Ausführungsbeispielen sind alternativ oder zusätzlich zu der winkelabhängigen Vorgabe einer Information, wie einer Detektionsschwelle, weitere Informationen vorgesehen.

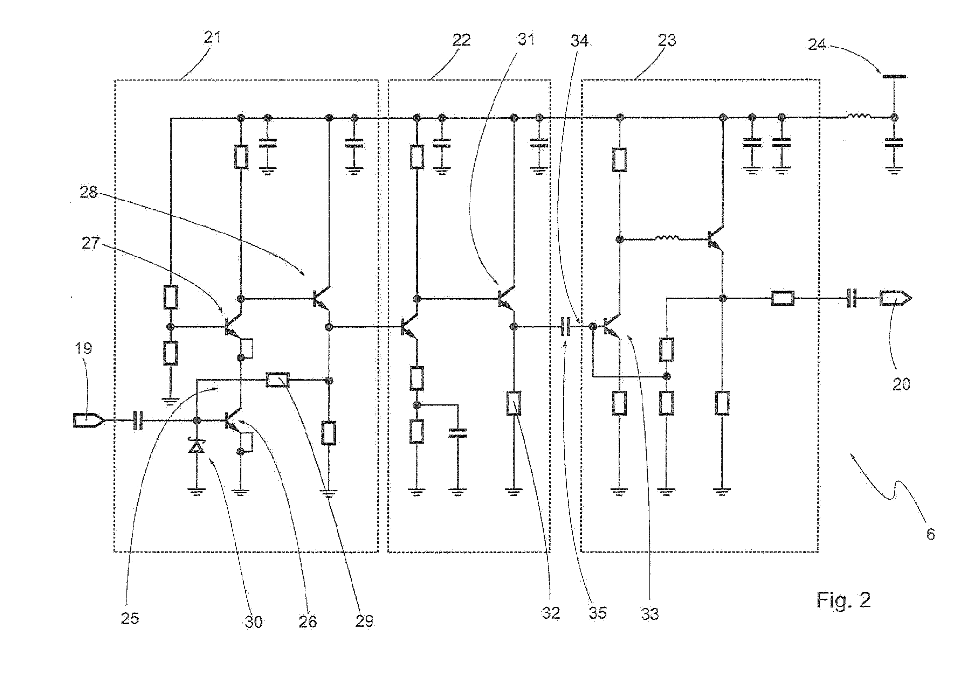

Fig. 2 zeigt ein Schaltbild des Transimpedanzverstärkers 6 gem. Fig. 1, welcher zwischen seinem Eingang 19 und seinem Ausgang 20 mehrere diskret hintereinander geschaltete Verstärkerstufen aufweist. Die Verstärkerstufen sind jeweils Verbundschaltungen mit zwei oder mehr Transistoren.

Eine erste Stufe 21 ist dabei als Transimpedanzverstärkungsschaltung und eine zweite Stufe 22 und eine dritte Stufe 23 jeweils als Spannungsverstärkungsschaltungen ausgebildet. Die diskrete Anordnung mehrerer Verstärkerstufen ermöglicht eine hohe Betriebsspannung der Gesamtschaltung, sodass die jeweiligen Arbeitspunkte in den einzelnen Verstärkerstufen im Hinblick auf die Aussteuerung des Empfangssignals optimal eingestellt werden können. Hierdurch wird die Dynamik des Transimpedanzverstärkers und damit des optischen Empfängers 3 (Fig. 1) erhöht. Eine Spannungsquelle 24 legt an jede der Verstärkerstufen eine Betriebsspannung an, welche vorteilhaft mehr als 7 Volt beträgt und somit die Signalaussteuerbarkeit verbessert. Im gezeigten Ausführungsbeispiel beträgt die Betriebsspannung 10 Volt.

Die erste Stufe 21, welche als Transimpedanzverstärkungsschaltung ausgebildet ist, weist eine Kaskodenschaltung 25 mit einem Eingangstransistor 26 in Emitterschaltung und einen Ausgangstransistor 27 in Basisschaltung auf, wobei am Eingangstransistor 26 eine geringe negative Spannungsverstärkung auftritt und dadurch der so genannte Millereffekt stark reduziert wird. Der Arbeitspunkt der Kaskodenschaltung 25 ist auf das Rauschoptimum des Eingangstransistors 26 und des Ausgangstransistors 27 eingestellt.

Die erste Stufe 21 weist ausgangsseitig eine zusätzliche Kollektorschaltung 28 auf, welche sowohl einen Impedanzwandler bildet als auch eine diskrete und isolierte Anordnung der zweiten Stufe 22 ermöglicht.

Die erste Stufe 21 weist schließlich eine Rückkopplung über einen Rückkopplungswiderstand 29 auf den Eingang der Kaskodenschaltung 25 auf. Die Transimpedanz der ersten Stufe 21 wird dabei über die Größe des Rückkopplungswiderstands 29 eingestellt. Die Rückkopplung auf den Eingang der Kaskodenschaltung 25 hat ferner eine stabilisierende Wirkung auf den Arbeitspunkt der Kaskodenschaltung 25.

Dem Eingangstransistor 26 der Kaskodenschaltung 25 ist eine Schottky-Diode 30 zugeordnet, welche in der Basis-Emitter-Strecke des in Emitterkonfiguration angeordneten Eingangstransistors 26 der Kaskodenschaltung 25 liegt. Die Schottky-Diode 30 schützt die erste Stufe 21 bei Empfangssignalen mit sehr hohen Pegeln am Eingang 19 des Transimpedanzverstärkers 6 und verhindert das Zusammenbrechen des ausgangsseitigen Pulses an 20 bei hohen Empfangspegeln. Auf diese Weise wird die Dynamik des aus mehreren diskret hintereinander angeordneten Verstärkerstufen gebildeten Transimpedanzverstärkers 6 erhöht.

Im gezeigten Ausführungsbeispiel eines erfindungsgemäßen Transimpedanzverstärkers 6 für eine optoelektrische Detektionseinrichtung sind drei Verstärkerstufen vorgesehen, so dass eine hohe Gesamtverstärkung erzielt ist. Die zweite Stufe 22 und die dritte Stufe 23 sind jeweils Spannungsverstärkerschaltungen in Emitterkonfiguration mit Stromgegenkopplung und einer ausgangsseitigen Kollektorschaltung 31. Dabei isoliert die Kollektorschaltung 31 der zweiten Stufe 22 die zweite Stufe 22 von der dritten Stufe 23 und begrenzt zudem die Signalamplitude im Großsignalbetrieb. Dabei ist die zweite Stufe 22 derart konfiguriert und mit der Transimpedanzverstärkungsschaltung der ersten Stufe 21 abgestimmt, dass das Empfangssignal 5 am Eingang 19 des Transimpedanzverstärkers 1 und das Signal in Kollektorschaltung 31 der zweiten Stufe 22 phasengleich sind.

Die Ausgangsimpedanz der Kollektorschaltung 31 der zweiten Stufe 22 und die Eingangsimpedanz der dritten Stufe 23 sind derart durch Anordnung der entsprechenden Schaltungsbauteile konfiguriert, dass die Amplitude des Empfangssignals entsprechend der gewünschten Bandbreite begrenzt ist. Die Begrenzung der Signalamplitude wird maßgeblich durch die Größe eines Emitterwiderstands 32 der Kollektorschaltung 31 der zweiten Stufe 22 eingestellt.

Die erste Stufe 21, welche die Transimpedanzverstärkungsschaltung aufweist, ist mit der zweiten Stufe 22 gleichstromgekoppelt, wodurch eine stabile Basisvorspannung für die zweite Stufe 22 gegeben ist. Die Signalverstärkung der zweiten Stufe wird über die entsprechende Anordnung und Auswahl der elektronischen Bauteile der zweiten Stufe 22 frequenzselektiv eingestellt, wodurch eine hohe Wechselstromverstärkung gegeben ist. Zudem wird durch eine hohe Stromgegenkopplung der Arbeitspunkt der zweiten Stufe 22 stabilisiert.

Die dritte Stufe 23 ist eine Spannungsverstärkungsschaltung in Emitterkonfiguration mit Stromgegenkopplung und einer ausgangsseitigen Kollektorschaltung 31. Durch die Stromgegenkopplung wird der Arbeitspunkt des Eingangstransistors 33 in Emitterschaltung festgelegt, so dass eine Wechselstromkopplung von der zweiten Stufe 22 zu der dritten Stufe 23 über 35 möglich ist.

Im gezeigten Ausführungsbeispiel eines Transimpedanzverstärkers 6 mit drei diskret hintereinander geschalteten Verstärkerstufen ist die dritte Stufe 23 die abschließende Stufe, wobei der Ausgang 20 des Transimpedanzverstärkers 6 auf den Eingang 34 der dritten Stufe 23 rückgekoppelt ist. Die Verbundschaltung der dritten Stufe 23 stellt eine hohe Verstärkung bei optimaler Bandbreite und zudem guter Isolation zischen dem Ausgang und dem Eingang der Schaltung dar.

Die zweite Stufe 22 und die dritte Stufe 23 sind wechselstromgekoppelt, wobei zwischen der Verbundschaltung der zweiten Stufe 22 und der Verbundschaltung der dritten Stufe 23 ein Kondensator 35 angeordnet ist. Die Wechselstromkopplung der zweiten Stufe 22 und der dritten Stufe 23 erlaubt die Linearisierung des Phasenverlaufs der aus mehreren Verstärkerstufen gebildeten Gesamtschaltung über die Frequenz. Durch die konstante Gruppenlaufzeit bei linearisiertem Phasenverlauf wird das gepulste Empfangssignal 5 (Fig. 1) optimal verstärkt.

## Patentansprüche

1. Transimpedanzverstärker für eine abtastende optoelektronische Detektionseinrichtung (1), insbesondere Laserscanner für Kraftfahrzeuge, mit Transistorschaltungen zur Verstärkung eines aus reflektierten Strahlen (2) gebildeten elektrischen Empfangssignals (5),
**dadurch gekennzeichnet, dass**
der Transimpedanzverstärker (6) mehrere diskret hintereinander geschaltete Verstärkerstufen aufweist, wobei eine erste Stufe (21) als Transimpedanzverstärkungsschaltung ausgebildet ist und die weiteren Stufen (22, 23) als Spannungsverstärkungsschaltungen.

2. Transimpedanzverstärker nach Anspruch 1,
**dadurch gekennzeichnet, dass**
wenigstens eine der weiteren Stufen (22, 23) eine ausgangsseitige Kollektorschaltung (31) und eine derartige Konfiguration aufweist, dass das Empfangssignal (5) am Eingang (19) des Transimpedanzverstärkers (6) und das Signal in der Kollektorschaltung (31).dieser Stufe (22) phasengleich sind.

3. Transimpedanzverstärker nach Anspruch 1 oder 2,
**dadurch gekennzeichnet, dass**
die erste Stufe (21) eine Kaskodenschaltung (25) und eine zusätzliche ausgangsseitige Kollektorschaltung (28) aufweist.

4. Transimpedanzverstärker nach Anspruch 2 oder 3,
**dadurch gekennzeichnet, dass**
die erste Stufe (21) eine Rückkopplung über einen Rückkopplungswiderstand (29) auf den Eingang der Kaskodenschaltung (25) aufweist.

5. Transimpedanzverstärker nach einem der Ansprüche 2 bis 4,
**dadurch gekennzeichnet, dass**
dem Eingangstransistor (26) der Kaskodenschaltung (25) eine Schottky-Diode (30) zugeordnet ist.

6. Transimpedanzverstärker nach einem der Ansprüche 1 bis 5,
**dadurch gekennzeichnet, dass**
die erste Stufe (21) und die zweite Stufe (22) gleichstromgekoppelt sind.

7. Transimpedanzverstärker nach einem der Ansprüche 1 bis 6,
**dadurch gekennzeichnet, dass**
die zweite Stufe (22) und die dritte Stufe (23) wechselstromgekoppelt sind.

8. Transimpedanzverstärker nach einem der Ansprüche 1 bis 7,
**gekennzeichnet durch**
eine Betriebsspannung des Transimpedanzverstärkers (6) von mindestens 7 Volt.

9. Verwendung eines Transimpedanzverstärkers (6) nach einem der vorhergehenden Ansprüche für eine abtastende optoelektronische Detektionseinrichtung (1), insbesondere die Detektionseinrichtung (1) eines Laserscanners, für ein Kraftfahrzeug, zur Verstärkung eines elektrischen Empfangssignals (5), welches ein optischer Empfänger (3) zum Empfangen von an einem Zielobjekt in einer Umgebung des Kraftfahrzeugs reflektierten Strahlen (2) bereitstellt.
